# FASCICULE DE BREVET EUROPEEN

(11) **EP 4 332 600 B1**
(45) Date de publication et mention de la délivrance du brevet: **06.05.2026**
(21) Numéro de dépôt: 23195195.5
(22) Date de dépôt: 04.09.2023
(51) Int. Cl.: G01R 31/52, H02H 1/00

(54) **DISPOSITIF DE DÉTECTION DE COURT-CIRCUIT ET VÉHICULE CORRESPONDANT**
KURZSCHLUSSERKENNUNGSVORRICHTUNG UND FAHRZEUG DAMIT
SHORT-CIRCUIT DETECTION DEVICE AND CORRESPONDING VEHICLE

(30) Priorité: 05.09.2022 FR 2208862
(43) Date de publication de la demande: 06.03.2024
(73) Titulaire: ALSTOM Holdings, 93400 Saint-Ouen-sur-Seine (FR)
(72) Inventeur: BOUALEM, Benali, 25660 Saone (FR); BALANDRET, Coralie, 25480 Miserey-Salines (FR); SOUILLE, Ronan, 25220 Thise (FR)
(74) Mandataire: Plasseraud IP

(56) Documents cités:
- EP-A1- 3 595 123
- DE-A1- 19 631 088
- US-A1- 2019 319 451

## Description

La présente invention concerne un dispositif de détection de court-circuit, comprenant une borne d'alimentation, une borne alimentée, un élément de liaison de la borne d'alimentation et de la borne alimentée, la borne d'alimentation, la borne alimentée et l'élément de liaison formant un tronçon de connexion électrique, qui est dépourvu d'isolation électrique, la borne d'alimentation et la borne alimentée comprenant chacune un tronçon isolé pourvu d'isolation électrique, et le dispositif de détection de court-circuit comprenant un élément de détection d'arc électrique émanant du tronçon de connexion électrique.

On connait la connexion électrique du moteur à son alimentation via une boite à bornes. Ceci permet un couplage et découplage simple du moteur de son alimentation tout en assurant dans la boite à bornes une détection des connexions électriques non-isolées dans une enceinte fermée et accessible uniquement par ouverture du couvercle de boite à bornes.

Un fonctionnement dégradé peut arriver dans la boite à bornes introduisant des courts-circuits et des arcs amenant à la destruction de la boite à bornes voire du bobinage. Généralement, les courts-circuits se produisent entre deux phases. Dans certains cas, tel que de moteur asynchrone, l'arrêt de l'alimentation permet de stopper le court-circuit.

Pour les moteurs utilisant des aimants permanents, l'arrêt de l'alimentation ne permet pas dans toutes les situations de stopper le court-circuit. En effet, si la position de la déconnexion de l'alimentation se trouve en amont de la zone de court-circuit, ce dernier va continuer à se propager si le moteur continue à tourner étant entrainé par la charge, comme dans le cas d'un véhicule ferroviaire comportant plusieurs moteurs de traction.

Un dispositif de détection est connu de la demande de brevet FR2737615A1. D'autres dispositifs sont connus de US6512444B1, DE2644422A1, US2021143629A1, DE102015016696A1 et US4067052A.

EP3595123 décrit un système de distribution d'énergie. DE19631088 décrit un dispositif de protection d'une installation électrique. US2019/319451 décrit un système de contrôle de chauffage de fenêtre.

L'invention a pour but de proposer un dispositif de détection de court-circuit qui est simple et économique, tout en étant fiable.

A cet effet, l'invention a pour objet un dispositif de détection tel qu'indiqué ci-dessus, caractérisé en ce que l'élément de détection comprend un élément électriquement conducteur, ayant un tronçon de détection, et un revêtement de détection qui est électriquement isolant et thermiquement dégradable et qui entoure le tronçon de détection, et en ce que le tronçon de détection s'étend à une distance de détection du tronçon de connexion électrique.

Selon des modes de réalisation particuliers du dispositif de détection, celui-ci peut comporter l'une ou plusieurs des caractéristiques suivantes :
la distance de détection est inférieure à une distance de portée d'un arc électrique émanant du tronçon de connexion électrique et adapté pour dégrader thermiquement le revêtement de détection, et/ou
la distance de détection est de telle sorte que d'une part la tension de claquage entre le tronçon de détection et le tronçon de connexion électrique en présence du revêtement de détection est supérieure à une tension nominale de la borne d'alimentation, et d'autre part la tension de claquage entre le tronçon de détection et le tronçon de connexion électrique, en l'absence du revêtement de détection, est inférieure à une tension nominale de la borne d'alimentation, et/ou
la distance de détection est inférieure à une distance entre le tronçon de connexion électrique et un élément de circuit électrique supplémentaire, qui est l'élément de circuit électrique le plus près de ce tronçon de connexion électrique ;
le revêtement de détection est un revêtement adapté pour se dégrader sous l'effet de la chaleur générée par un arc électrique, de préférence dans lequel le revêtement de détection comprend ou est constitué de polymère(s) sensible(s) à la chaleur, tel que PVC, fluoropolymère ou polypropylène, chimiquement dopé(s) conduisant à une diminution de résistance électrique dans le cas d'une augmentation de la température ;
l'élément électriquement conducteur est relié à la terre électrique ou à la masse électrique;
le dispositif de détection de court-circuit comprend un module de détection de court-circuit, qui est adapté pour détecter une mise à la masse électrique de la borne d'alimentation et de la borne alimentée par l'intermédiaire de l'élément électriquement conducteur;
l'élément électriquement conducteur de l'élément de détection a une section transversale circulaire, elliptique, carrée ou rectangulaire et/ou dans lequel l'élément électriquement conducteur est en forme de fil, de barre ou de nappe;
l'élément de détection soit consiste en une seule branche, soit forme une boucle à deux branches;
le dispositif de détection de court-circuit comprend une boîte à bornes,
la borne d'alimentation est disposée dans la boîte à bornes,
la borne alimentée est disposée dans la boîte à bornes,
l'élément de liaison est disposé dans la boîte à bornes, et
le tronçon de détection est disposé dans la boîte à bornes;
le dispositif de détection comprend une borne d'alimentation supplémentaire qui est disposée dans la boîte à bornes, une borne alimentée supplémentaire qui est disposée dans la boîte à bornes, un élément de liaison supplémentaire reliant la borne d'alimentation supplémentaire et la borne alimentée supplémentaire et qui est disposé dans la boîte à bornes,
la borne d'alimentation supplémentaire, la borne alimentée supplémentaire et l'élément de liaison supplémentaire définissant un tronçon de connexion électrique supplémentaire, dépourvu d'isolation électrique, et
la distance de détection est inférieure à la distance entre le tronçon de connexion électrique et le tronçon de connexion électrique supplémentaire, et
de préférence dans lequel la boite à bornes comprend une paroi de séparation entre le tronçon de connexion électrique et le tronçon de connexion électrique supplémentaire.

L'invention a également pour objet un véhicule comprenant un moteur électrique ayant au moins deux phases et un dispositif de détection de court-circuit relié au moteur électrique, caractérisé en ce que le dispositif de détection de court-circuit est un dispositif tel que défini ci-dessus.

L'invention sera mieux comprise à la lecture de la description qui va suivre, donnée uniquement à titre d'exemple et faite en se référant aux dessins annexés, sur lesquels :
[Fig 1] La Figure 1 montre d'une manière schématique un véhicule comprenant un dispositif de détection selon l'invention ;
[Fig 2] La Figure 2 montre une coupe du dispositif de détection selon la ligne II-II de la Figure 1; et
[Fig 3] La Figure 3 montre une variante d'un dispositif de détection des Figures 1 et 2, la vue de la Figure 3 correspondant à la vue de la Figure 2.

Dans ce qui suit, les expressions telles que « connecté », « relié », « isolé » se réfèrent, sauf indication contraire, à des caractéristiques électriques et non pas à des caractéristiques mécaniques.

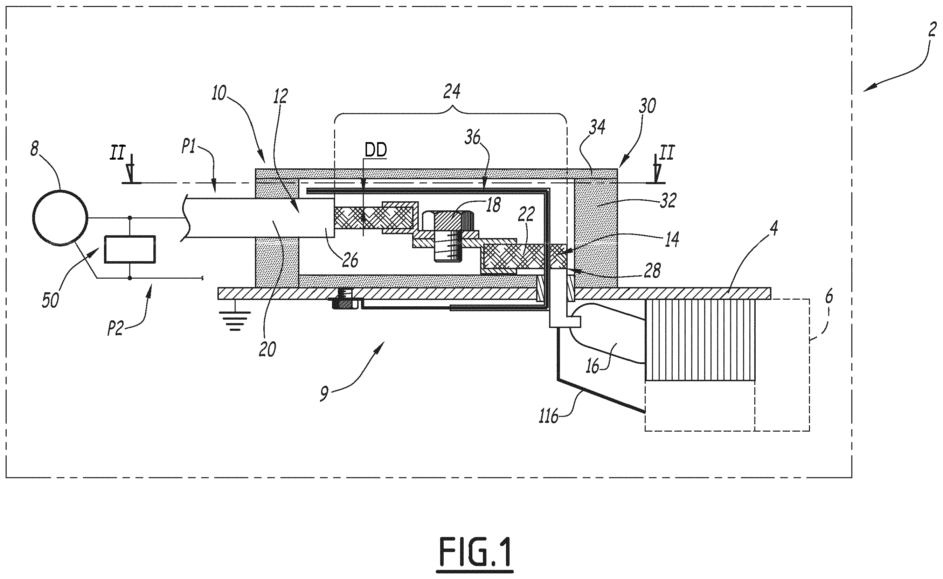

Sur la Figure 1 est représentée un véhicule désigné par la référence générale 2. Le véhicule 2 est dans le cas présent un véhicule ferroviaire telle qu'une locomotive et est représentée très schématiquement.

Le véhicule 2 comprend un châssis 4, relié à la terre électrique ou à la masse électrique, et au moins un moteur électrique 6, qui peut être un moteur synchrone ou asynchrone. Le moteur électrique 6 comprend deux ou trois phases, dont une phase P1 est représentée plus en détail et une phase supplémentaire P2 est représentée très schématiquement (voir ci-après). Le moteur électrique 6 est adapté pour entrainer des roues de traction du véhicule. Le véhicule 2 comprend une source de tension électrique 8 qui peut être une source de tension électrique direct ou alternatif et qui est adaptée pour alimenter le moteur électrique 6 en électricité. A cet effet, le moteur électrique 6 est connectée à la source de tension électrique 8 par un circuit de connexion électrique 9.

Le circuit de connexion électrique 9 comprend un dispositif de détection de court-circuit 10.

Le dispositif de détection de court-circuit 10 comprend une borne d'alimentation 12, connectée à la source de tension électrique 8, une borne alimentée 14, connectée au moteur électrique 6, dans le cas présent au bobinage d'un stator 16 du moteur électrique.

Le dispositif de détection de court-circuit 10 comprend un élément de liaison 18 de la borne d'alimentation et de la borne alimentée. Cet élément de liaison 18 relie d'une manière mécanique et électrique la borne d'alimentation et la borne alimentée et est par exemple une vis ou un boulon ou un autre élément de serrage mécanique.

La borne d'alimentation 12 comprend en l'occurrence une extrémité d'un câble 20 et la borne alimentée 14 comprend un embout de connexion de bobinage 22.

La borne d'alimentation 12, la borne alimentée 14 et l'élément de liaison 18 forment un tronçon de connexion électrique 24 qui est dépourvu d'isolation électrique et donc dénudé.

La borne d'alimentation 12 comprend un tronçon isolé 26 pourvu d'isolation électrique et la borne alimentée 14 comprend un tronçon isolé 28 pourvu d'isolation électrique.

Le dispositif de détection de court-circuit 10 comprend une boîte à bornes 30. La boite à bornes 30 est muni en l'occurrence d'un support de boîte à bornes 32 et d'un couvercle de boite à bornes 34. La borne d'alimentation 12 est disposée dans la boîte à bornes, la borne alimentée 14 est disposée dans la boîte à bornes et l'élément de liaison 18 est disposé dans la boîte à bornes. Les tronçons isolés 26, 28 sont prolongés et le prolongement s'étend à travers le support de boîte à bornes 32.

Le dispositif de détection de court-circuit 10 comprend par ailleurs un élément de détection 36 d'un arc électrique émanant du tronçon de connexion électrique 24. Cet élément de détection 36 comprend un élément électriquement conducteur 38 ayant un tronçon de détection 40.

L'élément électriquement conducteur 38 est relié à la masse électrique ou à la terre électrique, en l'occurrence au châssis 4.

L'élément électriquement conducteur 38 est par exemple en cuivre, aluminium ou en acier.

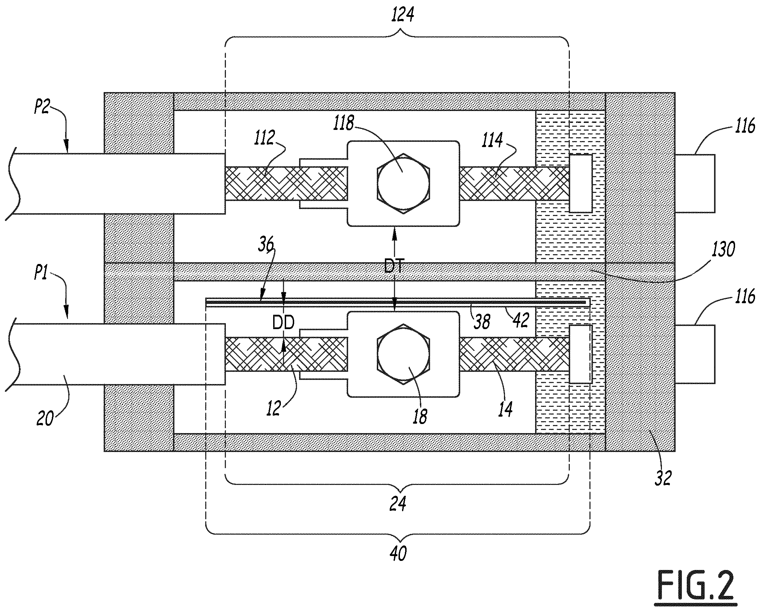

L'élément de détection 36 comprend un revêtement de détection 42 qui est électriquement isolant et thermiquement dégradable (Figure 2). Le revêtement de détection 42 entoure le tronçon de détection 40 notamment sur toute sa longueur et/ou la totalité du tronçon de détection. En l'occurrence, le revêtement de détection entoure l'élément électriquement conducteur sur toute sa longueur dans la boite à bornes, sur un tronçon passant à travers une paroi de la boite à bornes 30, et une partie de sa longueur s'étendant depuis la boite à bornes 30. Uniquement un tronçon s'étendant en dehors de la boite à bornes 30 de l'élément de détection 36 est dénudé de revêtement de détection 42.

Le revêtement de détection 42 est un revêtement adapté pour se dégrader sous l'effet de la chaleur générée par un arc électrique. Le revêtement de détection peut comprendre ou être constitué de polymère(s) sensible(s) à la chaleur, tel que du PVC, fluoropolymère ou polypropylène, chimiquement dopé(s) conduisant à une diminution de résistance électrique dans le cas d'une augmentation de la température. La température de dégradation thermique, c'est-à-dire la température à partir de laquelle le revêtement thermique se dégrade, peut être comprise entre 80°C et 240°C et notamment entre 100°C et 200°C.

L'élément électriquement conducteur 38 de l'élément de détection peut avoir une section transversale circulaire, elliptique, carrée ou rectangulaire. L'élément électriquement conducteur peut être en forme de fil, de barre ou de nappe.

Dans le cas du mode de réalisation des Figures 1 et 2, l'élément de détection 36 consiste en une seule branche s'étendant à l'intérieur de la boite à bornes 30.

Le tronçon de détection 40 s'étend, notamment sur toute sa longueur et/ou sur toute son étendue, à une distance de détection DD du tronçon de connexion électrique 24.

La distance de détection DD est choisie de telle sorte que, lors de l'apparition d'un arc électrique au niveau du tronçon de connexion électrique 24, cet arc électrique dégrade thermiquement le revêtement de détection 42 et établit une connexion électrique par arc électrique entre le tronçon de connexion et l'élément électriquement conducteur 38. Cette connexion à la masse électrique ou à la terre électrique est ensuite détectée, par exemple par un module de détection 50 de court-circuit faisant partie du dispositif de détection. Ce module de détection 50 est par exemple un module adapté pour détecter une différence de courant entre deux phases par exemple P1 et P2 du circuit d'alimentation du moteur électrique 6 ou pour détecter un courant de fuite entre la phase et la masse électrique ou terre électrique (généralement comprenant le châssis 4 du véhicule) (Figure 1). En fonction de la détection d'un court-circuit par le module de détection 50, le module de détection peut émettre un signal de détection ou couper l'alimentation du moteur électrique 6. Le module de détection 50 de court-circuit peut par exemple comprendre un interrupteur différentiel ou un disjoncteur différentiel.

La distance de détection DD peut être déterminée par exemple comme suit :
- a) la distance de détection est inférieure à une distance de portée d'un arc électrique émanant du tronçon de connexion électrique 24 et adapté pour dégrader thermiquement le revêtement de détection 42 ; et/ou
- b) la distance de détection DD est de telle sorte que d'une part la tension de claquage entre le tronçon de détection 40 et le tronçon de connexion électrique 24 en présence du revêtement de détection est supérieure à une tension nominale de la borne d'alimentation, et d'autre part la tension de claquage entre le tronçon de détection et le tronçon de connexion électrique en l'absence du revêtement de détection est inférieure à une tension nominale de la borne d'alimentation ; et/ou
- c) la distance de détection DD est inférieure à une distance entre le tronçon de connexion électrique 24 et un élément de circuit électrique supplémentaire, qui est l'élément de circuit électrique le plus près de ce tronçon de connexion électrique.

Pour le cas c), l'élément de circuit électrique supplémentaire est par exemple un tronçon de connexion supplémentaire d'une autre phase du même moteur électrique 6 (voir ci-dessous).

Pour des tensions électriques nominales comprises entre 1kV et 5kV, la distance de détection est par exemple comprise entre 1 mm et 5 mm. De manière générale, la distance de détection peut donc être comprise entre 1,0 mm et 5,0 mm.

En l'occurrence, le tronçon de détection 40 est disposé dans la boîte à bornes 30.

Comme ceci est visible sur la Figure 2, le dispositif de détection de court-circuit 10 peut comprendre une borne d'alimentation supplémentaire 112 qui peut être disposée dans la boîte à bornes, une borne alimentée supplémentaire 114 qui peut être disposée dans la boîte à bornes, et un élément de liaison supplémentaire 118. L'élément de liaison supplémentaire 118 relie la borne d'alimentation supplémentaire et la borne alimentée supplémentaire et peut également être disposé dans la boîte à bornes. Ces éléments supplémentaires : la borne d'alimentation supplémentaire 112, la borne alimentée supplémentaire 114 et l'élément de liaison supplémentaire 118 peuvent être respectivement identiques aux éléments précédemment décrits 12, 14, 18. Ces éléments supplémentaires font par exemple partie d'une phase supplémentaire P2 pour alimenter le moteur électrique 6 en électricité. Le moteur électrique 6 comprend à cet effet un bobinage de stator supplémentaire 116.

La borne d'alimentation supplémentaire 112, la borne alimentée supplémentaire 114 et l'élément de liaison supplémentaire 118 définissent un tronçon de connexion électrique supplémentaire 124 dépourvu d'isolation électrique.

Da distance de détection DD est inférieure à la distance de tronçon DT entre le tronçon de connexion électrique 24 et le tronçon de connexion électrique supplémentaire 124.

La boite à bornes 30 comprend en l'occurrence une paroi de séparation 130 entre le tronçon de connexion électrique et le tronçon de connexion électrique supplémentaire.

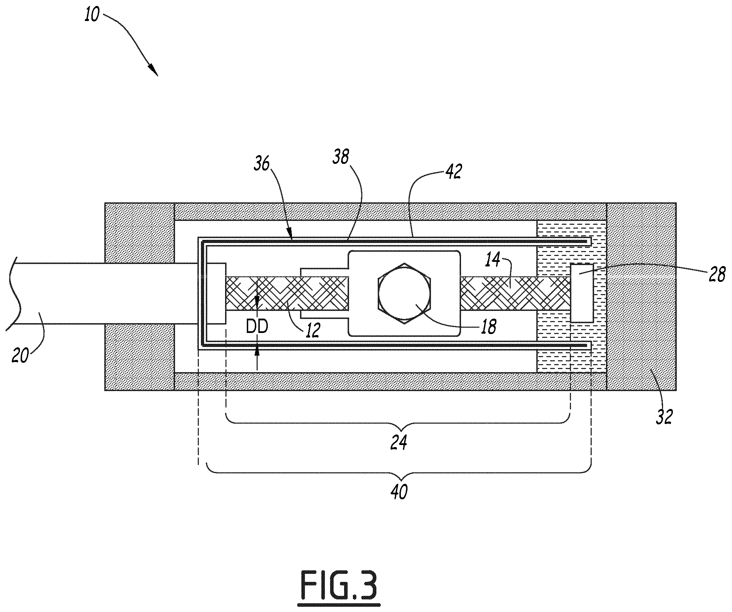

Le mode de réalisation de la Figure 3 diffère du mode de réalisation décrit ci-dessus uniquement par ce qui suit. Les éléments analogues portent les mêmes références.

Dans le cas du mode de réalisation de la Figure 3, l'élément de détection 36 forme une boucle à deux branches.

Le dispositif de détection selon l'invention permet de détecter avec des moyens simples et économiques l'apparition d'un arc électrique. Le dispositif de détection est également adapté pour équiper des circuits électriques existants (retrofit).

La description qui précède contient des caractéristiques techniques de l'invention. Ces caractéristiques techniques, bien que présentées dans un contexte technique et éventuellement en combinaison avec d'autres caractéristiques techniques, peuvent être utilisées à chaque fois individuellement, sans les autres caractéristiques techniques, pour autant que ceci soit techniquement possible.

## Revendications

1. Dispositif de détection de court-circuit, comprenant une borne d'alimentation (12),
une borne alimentée (14),
un élément de liaison (18) de la borne d'alimentation et de la borne alimentée,
la borne d'alimentation, la borne alimentée et l'élément de liaison formant un tronçon de connexion électrique (24), qui est dépourvu d'isolation électrique,
la borne d'alimentation et la borne alimentée comprenant chacune un tronçon isolé (26, 28) pourvu d'isolation électrique,
le dispositif de détection de court-circuit comprenant un élément de détection (36) d'arc électrique émanant du tronçon de connexion électrique,
**caractérisé en ce que** l'élément de détection comprend un élément électriquement conducteur (38), ayant un tronçon de détection (40), et un revêtement de détection (42) qui est électriquement isolant et thermiquement dégradable et qui entoure le tronçon de détection, et **en ce que**
le tronçon de détection (40) s'étend à une distance de détection (DD) du tronçon de connexion électrique.

2. Dispositif de détection de court-circuit selon la revendication 1, dans lequel
la distance de détection (DD) est inférieure à une distance de portée d'un arc électrique émanant du tronçon de connexion électrique (24) et adapté pour dégrader thermiquement le revêtement de détection (42), et/ou
la distance de détection (DD) est de telle sorte que d'une part la tension de claquage entre le tronçon de détection (40) et le tronçon de connexion électrique (24) en présence du revêtement de détection (42) est supérieure à une tension nominale de la borne d'alimentation, et d'autre part la tension de claquage entre le tronçon de détection et le tronçon de connexion électrique, en l'absence du revêtement de détection, est inférieure à une tension nominale de la borne d'alimentation, et/ou
la distance de détection (DD) est inférieure à une distance (DT) entre le tronçon de connexion électrique (24) et un élément de circuit électrique supplémentaire, qui est l'élément de circuit électrique le plus près de ce tronçon de connexion électrique.

3. Dispositif de détection de court-circuit selon la revendication 1 ou 2, dans lequel le revêtement de détection (42) est un revêtement adapté pour se dégrader sous l'effet de la chaleur générée par un arc électrique, de préférence dans lequel le revêtement de détection (42) comprend ou est constitué de polymère(s) sensible(s) à la chaleur, tel que PVC, fluoropolymère ou polypropylène, chimiquement dopé(s) conduisant à une diminution de résistance électrique dans le cas d'une augmentation de la température.

4. Dispositif de détection de court-circuit selon l'une quelconque des revendications précédentes, dans lequel l'élément électriquement conducteur (38) est relié à la terre électrique ou à la masse électrique.

5. Dispositif de détection de court-circuit selon l'une quelconque des revendications précédentes, dans lequel le dispositif de détection de court-circuit comprend un module de détection (50) de court-circuit, qui est adapté pour détecter une mise à la masse électrique de la borne d'alimentation et de la borne alimentée par l'intermédiaire de l'élément électriquement conducteur (38).

6. Dispositif de détection de court-circuit selon l'une quelconque des revendications précédentes, dans lequel l'élément électriquement conducteur (38) de l'élément de détection a une section transversale circulaire, elliptique, carrée ou rectangulaire et/ou dans lequel l'élément électriquement conducteur est en forme de fil, de barre ou de nappe.

7. Dispositif de détection de court-circuit selon l'une quelconque des revendications précédentes, dans lequel l'élément de détection soit consiste en une seule branche, soit forme une boucle à deux branches.

8. Dispositif de détection de court-circuit selon l'une des revendications précédentes, dans lequel
le dispositif de détection de court-circuit comprend une boîte à bornes (30),
la borne d'alimentation (12) est disposée dans la boîte à bornes,
la borne alimentée (14) est disposée dans la boîte à bornes,
l'élément de liaison (18) est disposé dans la boîte à bornes, et
le tronçon de détection (40) est disposé dans la boîte à bornes.

9. Dispositif de détection de court-circuit selon la revendication 8, dans lequel
le dispositif de détection comprend une borne d'alimentation supplémentaire (112) qui est disposée dans la boîte à bornes, une borne alimentée supplémentaire (114) qui est disposée dans la boîte à bornes, un élément de liaison supplémentaire (118) reliant la borne d'alimentation supplémentaire et la borne alimentée supplémentaire et qui est disposé dans la boîte à bornes (30),
la borne d'alimentation supplémentaire, la borne alimentée supplémentaire et l'élément de liaison supplémentaire définissant un tronçon de connexion électrique supplémentaire (124), dépourvu d'isolation électrique, et dans lequel
la distance de détection est inférieure à la distance (DT) entre le tronçon de connexion électrique et le tronçon de connexion électrique supplémentaire, et
de préférence dans lequel la boite à bornes comprend une paroi de séparation (130) entre le tronçon de connexion électrique et le tronçon de connexion électrique supplémentaire.

10. Véhicule (2), notamment véhicule ferroviaire, du type comprenant un moteur électrique (6) ayant au moins deux phases (P1 ; P2) et un dispositif de détection de court-circuit (10) relié au moteur électrique, **caractérisé en ce que** le dispositif de détection de court-circuit est un dispositif selon l'une quelconque des revendications précédentes.

## Patentansprüche

1. Kurzschluss-Detektionsvorrichtung, umfassend:
einen Versorgungsanschluss (12),
einen versorgten Anschluss (14),
ein Kopplungselement (18) des Versorgungsanschlusses und des versorgten Anschlusses,
wobei der Versorgungsanschluss, der versorgte Anschluss und das Kopplungselement einen elektrischen Verbindungsabschnitt (24) bilden, welcher frei von elektrischer Isolierung ist,
wobei der Versorgungsanschluss und der versorgte Anschluss jeweils einen isolierten Abschnitt (26, 28) umfassen, welcher mit elektrischer Isolierung versehen ist,
wobei die Kurzschluss-Detektionsvorrichtung ein Detektionselement (36) für einen Lichtbogen umfasst, welcher von dem elektrischen Verbindungsabschnitt ausgeht,
**dadurch gekennzeichnet, dass** das Detektionselement ein elektrisches Leitungselement (38) umfasst, welches einen Detektionsabschnitt (40) und
eine Detektionsbeschichtung (42) aufweist, welche elektrisch isolierend und thermisch abbaubar ist und welche den Detektionsabschnitt umgibt, und
dadurch, dass
sich der Detektionsabschnitt (40) bei einer Detektionsdistanz (DD) von dem elektrischen Verbindungsabschnitt erstreckt.

2. Kurzschluss-Detektionsvorrichtung nach Anspruch 1, wobei
die Detektionsdistanz (DD) kleiner als eine Reichweite eines Lichtbogens ist, welcher von dem elektrischen Verbindungsabschnitt (24) ausgeht und dazu eingerichtet ist, die Detektionsbeschichtung (42) thermisch abzubauen, und/oder
die Detektionsdistanz (DD) derart ist, dass einerseits die Durchschlagspannung zwischen dem Detektionsabschnitt (40) und dem elektrischen Verbindungsabschnitt (24) bei Vorliegen der Detektionsbeschichtung (42) größer als eine Nominalspannung des Versorgungsanschlusses ist und andererseits die Durchschlagspannung zwischen dem Detektionsabschnitt und dem elektrischen Verbindungsabschnitt in Abwesenheit der Detektionsbeschichtung kleiner als eine Nominalspannung des Versorgungsanschlusses ist, und/oder die Detektionsdistanz (DD) kleiner als eine Distanz (DT) zwischen dem elektrischen Verbindungsabschnitt (24) und einem zusätzlichen elektrischen Schaltungselement ist, welches das elektrische Schaltungselement ist, welches dem elektrischen Verbindungsabschnitt am nächsten ist.

3. Kurzschluss-Detektionsvorrichtung nach Anspruch 1 oder 2, wobei die Detektionsbeschichtung (42) eine Beschichtung ist, welche dazu eingerichtet ist, unter der Wirkung von Wärme abgebaut zu werden, welche durch einen Lichtbogen erzeugt wird, wobei vorzugsweise die Detektionsbeschichtung (42) umfasst oder aufgebaut ist aus wärmeempfindlichem/n Polymer(en), wie beispielsweise PVC, Fluorpolymer oder Polypropylen, welche(s) chemisch dotiert ist/sind, was zu einer Verringerung des elektrischen Widerstands in dem Fall eines Anstiegs der Temperatur führt.

4. Kurzschluss-Detektionsvorrichtung nach einem der vorhergehenden Ansprüche, wobei das elektrische Leitungselement (38) an die elektrische Erdung oder die elektrische Masse angeschlossen ist.

5. Kurzschluss-Detektionsvorrichtung nach einem der vorhergehenden Ansprüche, wobei die Kurzschluss-Detektionsvorrichtung ein Kurzschluss-Detektionsmodul (50) umfasst, welches dazu eingerichtet ist, ein Anlegen an die elektrische Masse des Versorgungsanschlusses und des versorgten Anschlusses mittels des elektrischen Leitungselements (38) zu detektieren.

6. Kurzschluss-Detektionsvorrichtung nach einem der vorhergehenden Ansprüche, wobei das elektrische Leitungselement (38) des Detektionselements einen kreisförmigen, elliptischen, quadratischen oder rechteckigen transversalen Querschnitt aufweist und/oder wobei das elektrische Leitungselement in Form eines Drahts, eines Stabes oder eines Bands vorliegt.

7. Kurzschluss-Detektionsvorrichtung nach einem der vorhergehenden Ansprüche, wobei das Detektionselement entweder aus einem einzelnen Zweig besteht oder eine Schleife mit zwei Zweigen bildet.

8. Kurzschluss-Detektionsvorrichtung nach einem der vorhergehenden Ansprüche, wobei
die Kurzschluss-Detektionsvorrichtung einen Anschlusskasten (30) umfasst, der Versorgungsanschluss (12) in dem Anschlusskasten angeordnet ist, der versorgte Anschluss (14) in dem Anschlusskasten angeordnet ist,
das Kopplungselement (18) in dem Anschlusskasten angeordnet ist, und der Detektionsabschnitt (40) in dem Anschlusskasten angeordnet ist.

9. Kurzschluss-Detektionsvorrichtung nach Anspruch 8, wobei
die Detektionsvorrichtung einen zusätzlichen Versorgungsanschluss (112), welcher in dem Anschlusskasten angeordnet ist, einen zusätzlichen versorgten Anschluss (114), welcher in dem Anschlusskasten angeordnet ist, und ein zusätzliches Kopplungselement (118) umfasst, welches den zusätzlichen Versorgungsanschluss und den zusätzlichen versorgten Anschluss koppelt und in dem Anschlusskasten (30) angeordnet ist,
wobei der zusätzliche Versorgungsanschluss, der zusätzliche versorgte Anschluss und das zusätzliche Kopplungselement einen zusätzlichen elektrischen Verbindungsabschnitt (124) bilden, welcher frei von elektrischer Isolierung ist, und wobei
die Detektionsdistanz kleiner als die Distanz (DT) zwischen dem elektrischen Verbindungsabschnitt und dem zusätzlichen elektrischen Verbindungsabschnitt ist, und
wobei vorzugsweise der Anschlusskasten eine Trennwand (130) zwischen dem elektrischen Verbindungsabschnitt und dem zusätzlichen elektrischen Verbindungsabschnitt umfasst.

10. Fahrzeug (2), insbesondere Schienenfahrzeug, von dem Typ, welcher einen Elektromotor (6) mit wenigstens zwei Phasen (P1: P2) und eine Kurzschluss-Detektionsvorrichtung (10) umfasst, welche mit dem Elektromotor verbunden ist, **dadurch gekennzeichnet, dass** die Kurzschluss-Detektionsvorrichtung eine Vorrichtung nach einem der vorhergehenden Ansprüche ist.

## Claims

1. Short-circuit detection device, comprising
a power supply terminal (12),
a powered terminal (14),
an element (18) for linking the power supply terminal and the powered terminal, the power supply terminal, the powered terminal and the linking element forming an electrical connection section (24), which is devoid of electrical insulation,
the power supply terminal and the powered terminal each comprising an insulated section (26, 28) provided with electrical insulation,
the short-circuit detection device comprising an element (36) for detecting electric arcs originating from the electrical connection section,
**characterised in that** the detection element comprises an electrically conductive element (38), having a detection section (40), and a detection coating (42) which is electrically insulating and thermally degradable and which surrounds the detection section, and **in that**
the detection section (40) extends at a detection distance (DD) from the electrical connection section.

2. Short-circuit detection device according to claim 1, wherein
the detection distance (DD) is less than a range distance of an electric arc from the electrical connection section (24) and adapted to thermally degrade the detection coating (42), and/or
the detection distance (DD) is such that, on the one hand, the breakdown voltage between the detection section (40) and the electrical connection section (24) in the presence of the detection coating (42) is greater than a nominal voltage of the power supply terminal, and, on the other hand, the breakdown voltage between the detection section and the electrical connection section, in the absence of the detection coating, is less than a nominal voltage of the power supply terminal, and/or
the detection distance (DD) is shorter than a distance (DT) between the electrical connection section (24) and an additional electric circuit element, which is the electric circuit element the closest to this electrical connection section.

3. Short-circuit detection device according to claim 1 or 2, wherein the detection coating (42) is a coating adapted to be degraded under the effect of heat generated by an electric arc, preferably wherein the detection coating (42) comprises or consists of heat-sensitive polymer(s), such as PVC, fluoropolymer or polypropylene, chemically doped resulting in a decrease in electrical resistance in the case of an increase in temperature.

4. Short-circuit detection device according to any of the preceding claims, wherein the electrically conductive element (38) is connected to the electrical earth or to the electrical ground.

5. Short-circuit detection device according to any one of the preceding claims, wherein the short-circuit detection device comprises a short-circuit detection module (50), which is adapted to detect electrical grounding of the power supply terminal and of the powered terminal via the electrically-conductive element (38).

6. Short-circuit detection device according to any of the preceding claims, wherein the electrically conductive element (38) of the detection element has a circular, elliptical, square or rectangular cross-section and/or wherein the electrically conductive element is in wire, bar or ribbon form.

7. Short-circuit detection device according to any one of the preceding claims, wherein the detection element either consists of a single arm, or forms a two-armed loop.

8. Short-circuit detection device according to one of the preceding claims, wherein the short-circuit detection device comprises a terminal box (30),
the power supply terminal (12) is disposed in the terminal box,
the powered terminal (14) is disposed in the terminal box,
the linking element (18) is disposed in the terminal box, and
the detection section (40) is disposed in the terminal box.

9. Short-circuit detection device according to claim 8, wherein
the detection device comprises an additional power supply terminal (112) which is disposed in the terminal box, an additional powered terminal (114) which is disposed in the terminal box, an additional linking element (118) connecting the additional power supply terminal and the additional powered terminal and which is disposed in the terminal box (30),
the additional power supply terminal, the additional powered terminal and the additional linking element defining an additional electrical connection section (124), devoid of electrical insulation, and wherein
the detection distance is less than the distance (DT) between the electrical connection section and the additional electrical connection section, and
preferably wherein the terminal box comprises a separating wall (130) between the electrical connection section and the additional electrical connection section.

10. Vehicle (2), particularly a railway vehicle, of the type comprising an electric motor (6) having at least two phases (P1; P2) and a short-circuit detection device (10) connected to the electric motor, **characterised in that** the short-circuit detection device is a device according to any of the preceding claims.
